Europäisches Patentamt

(19) European Patent Office

Office européen des brevets

(11) Publication number: **0 172 405
B1**

(12) **EUROPEAN PATENT SPECIFICATION**

(45) Date of publication of patent specification: **12.04.89**

(51) Int. Cl.⁴: **G 01 J 1/42**

(21) Application number: **85108862.5**

(22) Date of filing: **16.07.85**

(54) Circuitry for a portable test strip reading instrument.

(30) Priority: **26.07.84 US 634607
26.07.84 US 634574
26.07.84 US 634573**

(43) Date of publication of application:
**26.02.86 Bulletin 86/09**

(45) Publication of the grant of the patent:
**12.04.89 Bulletin 89/15**

(84) Designated Contracting States:
**DE FR GB IT SE**

(56) References cited:
**DE-A-2 713 655
DE-A-2 721 486
DE-A-3 236 773
GB-A-2 088 155
US-A-4 387 977**

(73) Proprietor: **MILES INC.
1127 Myrtle Street
Elkhart Indiana 46514 (US)**

(72) Inventor: **Loessel, Mark C.
637 Misty Harbour Court
Mishawaka Indiana 46544 (US)**
Inventor: **Miller, Randall W.
19616 Heritage Way
Goshen Indiana 46526 (US)**
Inventor: **Myers, Robert W.
1225 E. Third Street
Mishawaka Indiana 46544 (US)**

(74) Representative: **Kirchner, Dietrich, Dr. et al
c/o BAYER AG Konzernverwaltung RP
Patentabteilung
D-5090 Leverkusen, Bayerwerk (DE)**

Courier Press, Leamington Spa, England.

EP 0 172 405 B1

# Description

The present invention relates to improvements in an instrument for performing reflectance readings of reagent strips, wherein the reflectance readings are converted to concentration values which are then displayed. Specifically, the present invention is directed to a portable test strip reading instrument having a microcomputer, a battery power source and analog and digital circuitry connected to the microcomputer including a sensor-integrator circuit and in particular implies improvements in power efficiency and economy of control lines in such an instrument.

Instruments of this type are known in the prior art; in particular a leading device is the Glucometer™ manufactured by MILES INC. The instrument is a portable battery powered device of the type wherein a sample is placed on a reagent strip and the reagent strip is placed in the instrument to obtain the readings desired by the user.

An instrument of this type includes a photoelectric device, electronic circuitry including a microcomputer and an A/D converter and a display. A/D conversion was carried out in the aforementioned Glucometer by use of a sensor integrator circuit of the type set forth in US—Patent 4,313,067. Further the PCT—Application WO—A—83/00926 discloses a portable test strip reading instrument, comprising a test strip, a light sensitive device sensing light which is reflected from the test strip, the output of which is connected to an electronic measuring circuit which determines blood glucose level from the intensity of reflected light. The electronic measuring circuit is of the Wheatstone bridge type which is connected to an analog voltage regulator. The device is further provided with means for turning off the analog regulator when the analog measuring circuitry is not used.

The main object of the present invention is to provide an instrument which is an improvement over the prior art and wherein there is an economy of control lines to reduce manufacturing costs, and instrument size, wherein circuitry is utilized to reduce standby power to conserve the batteries used in the instrument so as to prolong their life.

According to the invention this object is solved as indicated in Claim 1.

Other objects and advantages of the present invention will become more apparent from the following detailed description of the invention when read in conjunction with the attached drawings which illustrate a preferred embodiment thereof, wherein:

Figure 1 is a schematic of the circuit according to the invention;

Figure 2A is a schematic of the A/D conversion circuitry which is part of the circuit according to Figure 1 and

Figure 2B is a wave form diagram of the operation of the circuitry of Figure 2A.

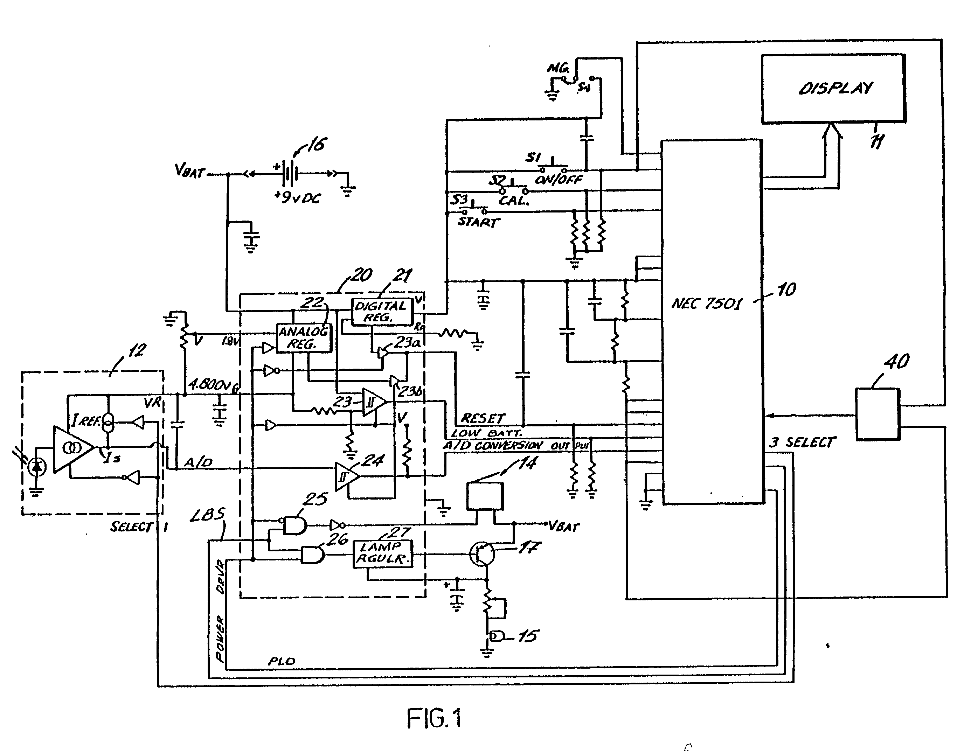

Referring now to Figure 1, the electrical circuitry for the instrument according to the present invention is shown. The circuitry includes a 4-bit microcomputer 10 which is preferably a NEC 7501 and which has its display outputs connected to a 3-digit LCD display 11.

The circuitry also includes a photo diode assembly 12 which is uniquely in the form of a transparent dual-in-line package. The photodiode assembly 12 has a select input which receives a logic 1 or a logic 0 from a control output from the microcomputer 10. The photodiode assembly 12 includes a voltage reference input $V_R$ and a current output which is either $I_{REF}$ or $I_S$, depending upon the state of the select input. This circuitry is connected to amplifier 24 and is all part of the A/D conversion circuitry described in lateron.

The microcomputer 10 is manually controlled by three pushbuttons S1—S3 which initiate the on/off function, the calibrate function and the start function respectively. A switch S4 is also provided for selecting between the display of milligrams per deciliter or millimoles per liter. Conventional resistive and capacitive buffering for the switches is provided as shown.

The circuitry also includes an indicator buzzer 14 as well as a lamp 15 for the optical illumination. The energy for the system is provided by a 9-volt battery 16 with the buzzer 14 and lamp 15 having a switching transistor 17 provided therefor.

The other analog and digital circuitry for the instrument that is contained in package 20 includes the digital voltage regulator 21 receptive of the battery voltage for generating the voltage for operating all of the digital circuitry in the instrument and the analog voltage regulator 22 which generates the voltage necessary for all of the analog circuitry in the instrument.

Package 20 also includes a low battery voltage detect comparator 23 which provides this information to the microcomputer 10. AND gates 23a and 23b monitor the digital regulator output and the analog regulator output to indicate to the microcomputer that one or both are inoperative and thus a reset condition is indicated.

Gates 25 and 26 utilize two control signals from the microcomputer to control the buzzer and lamp during operation. Because the buzzer and lamp are never on at the same time, the control of the two are efficiently carried out with a minimum of control lines. Signal PLD selects either the buzzer or the lamp. The drive for either the lamp of the buzzer is furnished by LBS. The PLD signal is also applied to the analog regulator 22 as a control input. PLD is also fed to AND gate 23a via 23c and to 23b via 23d in order to ensure that a reset condition is generated from the proper regulator (22 or 21).

The gate 26 is followed by a lamp regulator circuit 27 which feeds the lamp driver 17.

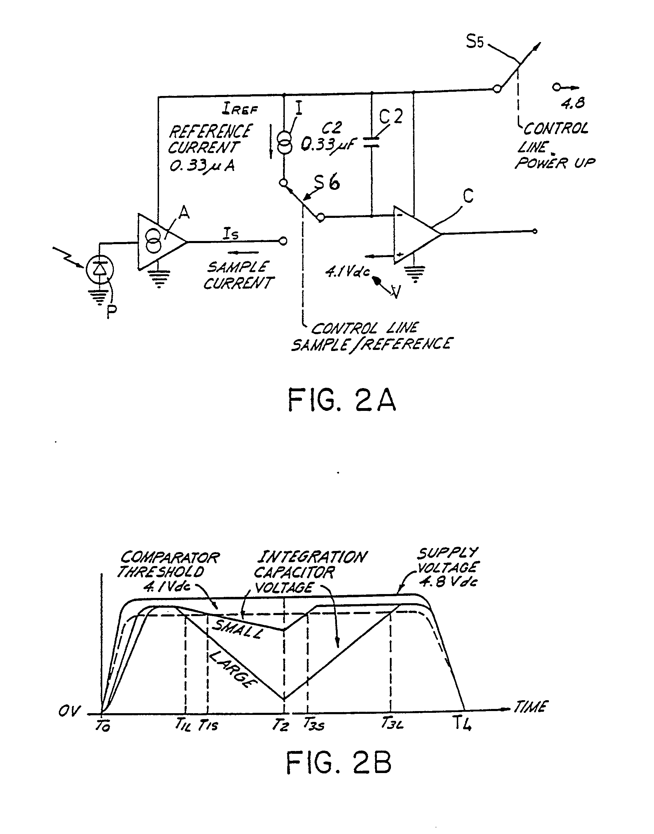

The circuitry shown in Figure 1 also includes a unique microcomputer clock 40 with a power down capability which significantly reduces the power consumption of the microcomputer. This circuitry is used in conjunction with amplifier 24 as part of the A/D conversion circuitry described in accordance with Figures 2A and 2B hereinafter.

The circuit in accordance with the present invention is a departure from the conventional dual slope integrator A/D converter in that it necessitates only a single control line and does not require a separate reset control in order to carry out successive A/D conversions.

The analog regulator is turned on for A/D conversions. Initially the analog regulator is off, and the capacitor is discharged. Since the voltage across a capacitor cannot change instantaneously, the voltage at both capacitor leads follows the analog regulator voltage, and the comparator is reset within the rise time of the regulator. The reset is accomplished in one millisecond. Selecting $I_{REF}$ maintains the reset state.

At time T1, the reference current is turned off and the sample current Is is selected. The sample current is then integrated for a fixed timee interval during T1 to T2 and this time has been preselected as one second.

At time T2, the select control line is reversed and the reference current $I_{REF}$ is selected. The reference current is reverse integrated to the reset voltage at a constant slope. The time at which the reset steady state voltage is reached is signified by time T3 and the A/D conversion is carried out by taking the ratio of (T3—T2) / (T2—T1) which is the ratio of the sample current to the reference current. By using a crystal oscillator as the time reference, the number of pulses counted during time T3—T2 will be a digital representation of the sample current as all of the other elements in that ratio are known parameters.

At time T4 (Fig. 2B), power can optionally be turned off for the circuitry to conserve the power consumption of the instrument. Thus the starting condition will be the same as T0. Alternatively, if a delay to the reset condition is undesirable, the powering down can be eliminated. Thus at time T4 the circuit will be at its reset condition and ready for the next conversion corresponding to time T1.

If the initial state of the circuitry is unknown, reset can always be accomplished by selecting $I_{REF}$ for the time necessary to reverse integrate the maximum $I_S$.

$$T\ reset \le \frac{(4.1)\ (.33\ \mu F)}{.33\ \mu A} = 4.1\ seconds$$

## Claims

1. A portable test strip reading instrument having a microcomputer (10), a battery power source (16) and analog and digital circuitry connected to the microcomputer (10) and including a sensor-integrator circuit (12) comprising sensing means (P) for producing a sample current ($I_S$) to be integrated and which varies in accordance with a sensed parameter and a comparator (C) having inverting and non-inverting inputs, an output and a positive voltage supply input, characterized in that charge storage means (C20) is connected between the inverting input and the voltage supply input of said comparator (C); means (S5, $V_R$, I) for applying a voltage to the voltage supply input and a reference current ($I_{REF}$) to the inverting input to produce a steady state positive voltage across the charge storage device (C20); means (Vc) for applying a reference voltage to the non-inverting input of the comparator (C) having a positive value less than but approximately equal to the steady state voltage; and transfer switch means (S6) requiring only a single control line (3 SELECT) for applying the sample current ($I_S$) to the inverting input of the comparator (C) instead of the reference current ($I_{REF}$) for a preselected known time period and thereafter applying again the reference current ($I_{REF}$) to the inverting input.

2. The instrument according to Claim 1 comprising an analog voltage regulator (22) and a digital voltage regulator (21) for the analog and digital circuitry, and means controlled by the microcomputer (10) for turning off the analog regulator (22) when the analog circuitry (12) is not utilized.

3. The instrument according to any of Claims 1 and 2, wherein the analog (22) and digital (21) regulators are disposed in a single integrated circuit package (20).

4. The instrument according to any of Claims 1 to 3, further comprising an indicator buzzer (14) and a lamp (15), gating means (25, 26) receptive of a first output signal from the microcomputer (10) for enabling both the lamp (15) and buzzer (14) to operate and a second output signal from the microcomputer (10) for alternately activating one of the buzzer (14) and lamp (15) when the first output signal is on.

5. The instrument according to Claim 4, wherein the gating means (25, 26) is disposed in said signal integrated circuit package (20).

## Patentansprüche

1. Tragbares Teststreifenlesegerät mit einem Mikrocomputer (10), einer Batterieenergiequelle (16) und einer analogen und digitalen Schaltung, die und den Mikrocomputer (10) angeschlossen ist und die eine Sensor-Integratorschaltung (12) enthält, welche eine Abtasteinrichtung (P) zur Erzeugung eines zu integrierenden Abtaststromes ($I_S$) aufweist, welcher sich in Übereinstimmung mit einem abgetasteten Parameter ändert, sowie mit einem Komparator (C) mit invertierenden und nicht-invertierenden Eingeängen, einem Ausgang und einem positiven Spannungsversorgungseingang, gekennzeichnet durch: eine Ladespeichereinrichtung (C20), die zwischen den invertierenden Eingang und den Spannungsversorgungseingang des Komparators (C) angeschlossen ist, eine Einrichtung (S5, $V_R$, I) zum Anlegen einer Spannung an den Spannungsversorgungseingang und eines Referenzstromes ($I_{REF}$) an den invertierenden Eingang, um eine unveränderliche positive Spannung über der Ladespeichervorrichtung (C20) zu erzeugen, eine Einrichtung (Vc) zum Anlegen einer Referenzspannung an den nicht invertierenden Eingang des Komparators (C) mit einem positiven Wert, der geringer als, jedoch nahezu gleich der unveränderlichen Spannung ist und eine Übertragungsschalteinrichtung (S6), die nur eine einzige Steuerleitung (3 SELECT) erfordert, um den Abtaststrom (I$_S$) an den invertierenden Eingang des Komparators (C) anstelle des Referenzstromes (I$_{REF}$) während einer vorgewählten bekannten Zeitperiode anzulegen, und um anschließend wieder den Referenzstrom (I$_{REF}$) dem invertierenden Eingang zuzuführen.

2. Gerät nach Anspruch 1, gekennzeichnet durch einen analogen Spannungsregler (22) und einen digitalen Spannungsregler (21) für die analoge und digitale Schaltung und durch den Mikrocomputer (10) gesteuerte Mittel zur Abschaltung des analogen Reglers (22) wenn die analoge Schaltung (12) nicht benützt wird.

3. Gerät nach Anspruch 1 oder 2, dadurch gekennzeichnet, daß der analoge (22) und digitale (21) Regler in einem einzigen integrierten Schaltbaustein (20) angeordnet sind.

4. Gerät nach einem der Ansprüche 1 bis 3, außberdem gekennzeichnet durch einem Schauzeichensummer (14) und eine Lampe (15), Torschaltungsmittel (25, 26) zum Empfang eines ersten Ausgangssignals vom Mikrocomputer (10), um sowohl die Lampe (15) als auch den Summer (14) dür den Betrieb friezugeben und eines zweiten Ausgangssignals vom Mikrocomputer (10), um abwechselnd den Summer (14) und die Lampe (15) zu aktivieren, wenn sich das erste Ausgangssignal im Ein-Zustand befindet.

5. Gerät nach Anspruch 4, dadurch gekennzeichnet, daß die Torschaltungsmittel (25, 26) in dem Signal-integrierten Schaltungsbaustein (20) angeordnet sind.

**Revendications**

1. Instrument portatif pour lecture de bandes de test, comportant un microcalculateur (10), une source d'alimentation avec batterie (16) et des circuits analogique et numérique reliés au microcalculateur (10), et incluant un circuit capteur-intégrateur (12) comprenant un moyen capteur (P) pour produire un courant d'échantillon (I$_S$) à

intégrer, qui varie en fonction d'un paramètre capté, et un comparateur (C) ayant des entrées inverseuse et non-inverseuse, une entrée de sortie et une entrée d'alimentation à tension positive, caractérisé en ce qu'un moyen de stockage de charge (C 20) est connecté entre l'entrée inverseuse et l'entrée d'alimentation en tension dudit comparateur (C); des moyens (S5, V$_R$, I) pour appliquer une tension à l'entrée d'alimentation en tension et un courant de référence (I$_{REF}$) à l'entrée inverseuse, pour produire une tension positive d'état permanent aux bornes du dispositif de stockage de charge (C 20); un moyen (Vc) pour appliquer à l'entrée non-inverseuse de comparateur (C) une tension de référence ayant une valeur positive inférieure mais approximativement égale à tension d'état permanent; et un moyen commutateur de transfert (S6) n'exigeant qu'une seule ligne de commande (3 SELECT) pour appliquer le courant d'échantillon (I$_S$) à l'entrée inverseuse de comparateur (C) au lieu du courant de référence (I$_{REF}$) pendant une période de temps présélectionnée connue, et appliquer ensuite de nouveau le courant de référence (I$_{REF}$) à l'entrée inverseuse.

2. Instrument selon revendication 1, comprenant un régulateur de tension analogique (22) et un régulateur de tension numérique (21) pour les circuits analogique et numérique, et des moyens commandés par le microcalculateur (10) pour inactiver le régulateur analogique (22) lorsque le circuit analogique (12) n'est pas utilisé.

3. Instrument selon l'une quelconque des revendications 1 et 2, dans lequel les régulateurs analogique (22) et numérique (21) sont disposés en un seul ensemble à circuit intégré (20).

4. Instrument selon l'une quelconque des revendications 1 à 3, comprenant en outre un indicateur sonore (14) et une lampe (15), des moyens de porte (25, 26) recevant un premier signal de sortie du microcalculateur (10), pour autoriser le fonctionnement de la lampe (15) et de l'indicateur sonore (14), et un deuxième signal de sortie provenant du microcalculateur (10) pour activer alternativement l'indicateur sonore (14) et la lampe (15) lorsque le premier signal de sortie est actif.

5. Instrument selon revendication 4, dans lequel les moyens de porte (25, 26) sont disposés dans ledit ensemble à circuit intégré (20).

FIG.1

EP 0 172 405 B1

FIG. 2A

FIG. 2B